# EUROPEAN PATENT APPLICATION

(11) **EP 4 492 440 A1**
(43) Date of publication of application: **15.01.2025**
(21) Application number: 24164661.1
(22) Date of filing: 19.03.2024
(51) Int. Cl.: H01L 21/67, H01L 21/677

(54) **SUBSTRATE PROCESSING SYSTEM**

(30) Priority: 10.07.2023 GB 202310581
(71) Applicant: SPTS Technologies Limited, Newport Gwent NP18 2TA (GB)
(72) Inventor: NAGY, Attila, Newport (GB); JONES, Chris, Newport (GB); WALLER, Phil, Newport (GB)
(74) Representative: Wynne-Jones IP Limited

(57) **Abstract**

A substrate processing system and a method of processing a substrate using a substrate processing system are provided.

## Description

### Background

This invention relates to a substrate processing system. This invention also relates also to a method of processing a substrate using a substrate processing system.

In Ultra High Vacuum (UHV) substrate processing equipment, such as thin film vacuum process equipment, it is standard practice to carry out a number of process steps in one process tool. The substrates being processed, semiconductor wafer, glass panels or the like, may require a variety of different steps to be undertaken in different parts of the process tool under reduced pressures. Vacuum compatible robots are frequently used to move the substates through the tool. A typical process sequence may require the substrates to be transferred into a vacuum environment from an atmospheric equipment front end module (EFEM) through load lock chambers into at least one transfer vacuum chamber, followed by a series of deposition or etch steps with various heating and cooling operations. Potentially in-tool metrology stations can also be used to measure various physical properties of the films on the substrate or the substrate itself. Once the required process sequence is completed, the substrates are returned through the load lock chambers back into the EFEM. Each of these process steps typically requires at least one dedicated module to perform a specific function and a transfer mechanism to move the substrate in a timely fashion through the process tool. The Cost of Ownership (CoO) of a process tool in a semiconductor wafer fabrication process is largely determined by the productivity of the tool (number of wafers per hour), the cost of consumables (cost per wafer), the footprint (area) of the system and the cost of the tool. In systems where there are a number of sequential process steps - such as in a PVD system - where the wafer is pre-heated, sputter cleaned, followed by two to three deposition steps in an ultra-high vacuum environment, the transport system can pay a significant role in determining tool throughput. For octagonal transport modules with two load lock chambers and a single bi-symmetric robot, throughput of the system can be limited by the number of process modules that can be accommodated by the transfer chamber, in this case, up to 6 process modules. In alternative systems, such as the industry standard AMAT Endura disclosed in US 5186718, two transfer chambers, each with a transfer robot and internal transport paths through load lock chambers between the transfer chambers, can provide up to 9 process module positions, 4 on the front transfer chamber and 5 on the rear transfer chamber. Some of the module positions on the front transfer chamber can only accommodate relatively small modules, due to the close proximity to the EFEM. The number of process modules that a transfer chamber can support is dependent on module size, mainly the width, and the module access requirements and type e.g. Physical Vapour Deposition (PVD), plasma or chemical etching, Chemical Vapour Deposition (CVD) or Atomic Layer Deposition (ALD). Different types of modules can have differing vacuum requirements, which need to be managed to avoid cross contamination issues. This is typically managed by maintaining different levels of vacuum in the front transfer chamber and back transfer chamber. However, the handling sequence in this twin transfer chamber system can limit productivity, as wafers processed in the first vacuum chamber need to be placed in the load lock chambers and equilibrated before entering the second chamber before being picked up by the second robot and moved to the next process station. When running sequential processes with parallel process paths, the handling time can be a limiting factor in tool productivity. A further limitation is the width of the transfer chamber with load lock chambers when using a bi-symmetric robot. Conventional twin transfer chamber systems use two load lock chambers to avoid the width of the chamber extending, increasing chamber volume and in turn increasing the tool footprint. In high volume applications, only having two load lock chambers can be the limiting factor in tool productivity.

### Statement of Invention

The present invention, in at least some of its embodiments, seeks to address some of the above-described problems, desires and needs. In particular, embodiments of the invention seek to improve the throughput and efficiency of substrate processing systems whilst minimising the footprint of the system.

According to a first aspect of the invention, there is provided a substrate processing system comprising:
- a transfer vacuum chamber for handling a substrate under vacuum conditions, the transfer vacuum chamber being in communication with at least two substrate modules connected to the transfer vacuum chamber by a respective connection slot, the at least two substrate modules being capable of receiving at least one substrate, wherein at least one of the at least two substrate modules is a substrate processing module; and
- at least two load lock chambers in vacuum communication with the transfer vacuum chamber;
wherein the transfer vacuum chamber comprises at least two transfer robots disposed within the transfer vacuum chamber configured to transfer a substrate between the at least two load lock chambers and the at least one substrate processing module under vacuum conditions, wherein the at least two transfer robots are each capable of translation along or rotation about at least five independent axes, and the at least two transfer robots are each configured to dispose and retrieve a substrate from at least one common substrate module of the at least two substrate modules.

By including at least two "five axis" transfer robots in a single transfer vacuum chamber, along with at least two load lock chambers and at least one common substrate module connected to the transfer vacuum chamber, the present inventors have found that a high productivity system with a relatively compact footprint can be produced, where throughput is principally constrained by the handling times of the substrates in the at least one substrate processing chamber, rather than the transport of the substrate. The at least one common substrate module that is accessible by each of the transfer robots prevents the need for additional transfer vacuum chambers or load lock chambers or other means of transporting substrates between areas accessible to each transfer vacuum robots, whilst also ensuring that the transfer vacuum chamber itself is absent of any structures or modules that could impede the path or motion of either of the transfer robots, allowing for reduced substrate transfer times and higher system throughput. Additionally, by using the "five axis" robots, the width of the chamber is primarily dictated by the size and number of load lock chambers, which can be located closer together as the "five axis" robots are not limited to radial movement, unlike a bi-symmetric robot. This allows for the width, and therefore the footprint, of the substrate processing system to be reduced.

Each connection slot can comprise an opening in the transfer vacuum chamber between the exterior and interior of the transfer vacuum chamber. Each connection slot can comprise a respective connection slot valve configured to isolate the interior of the transfer vacuum chamber from the exterior of the transfer vacuum chamber, thereby ensuring that a vacuum can be maintained inside the transfer vacuum chamber and a substrate module connected to the transfer vacuum chamber by the connection slot valve can be isolated from the transfer vacuum chamber. The transfer vacuum chamber can be configured, in use, to maintain a vacuum having a pressure of less than 3×10⁻⁷ Torr, optionally less than 1×10⁻⁷ Torr, further optionally approximately 9×10⁻⁸ Torr. The vacuum in the transfer vacuum chamber can be maintained by any known method in the art, such as a vacuum pump.

The at least two load lock chambers can be connected to an Equipment Front End Module (EFEM) configured to allow substrates to be loaded into and unloaded from the substrate processing system. The EFEM can comprise a third transfer robot configured to transfer a substrate between the at least two load lock chambers and the exterior of the EFEM under atmospheric conditions.

The at least one substrate processing module can comprise a substrate module configured to perform a Physical Vapour Deposition (PVD), plasma or chemical etching or deposition, Chemical Vapour Deposition (CVD) or Atomic Layer Deposition (ALD) process on at least one substrate. At least one substrate module of the at least two substrate modules that is not a substrate processing module can be an auxiliary substrate module, such as a multi- or single substrate cool down module, a multi- or single substrate buffer module, a pre-heat module and/or a metrology module.

The transfer vacuum chamber can comprise a plurality of facets, each facet comprising at least one connection slot, wherein each of the at least two substrate modules and the at least two load lock chambers are connected to the transfer vacuum chamber at a facet by a respective connection slot. Each of the at least two load lock chambers can be connected to the transfer vacuum chamber at a common load lock facet. The at least two load lock chamber can comprise three load lock chambers, wherein each of the three load lock chambers are connected to the transfer vacuum chamber at the load lock facet. When the at least two load lock chambers are connected to the transfer vacuum chamber at a common load lock facet, the transfer vacuum chamber can comprise two facets adjacent to the load lock facet, wherein each of the two facets are inclined toward the load lock facet. The two facets adjacent to the load lock facet can be inclined at an angle of up to 15° to a normal of the plane containing the load lock facet. This configuration of facets has been found to maximise space around the facets adjacent to the load lock facet, allowing larger substrate modules to be mounted adjacent to the load lock chambers and, if present, the EFEM, whilst minimising the footprint of the substrate processing system.

At least one facet can comprise an adjustable connection slot. Three facets can comprise a respective adjustable connection slot. The adjustable connection slot(s) can comprise at least one opening in the facet of the transfer vacuum chamber and a blanking plate, the blanking plate comprising at least one aperture, wherein the blanking plate is removably secured to the facet such that the least one aperture is positioned over the at least one opening. By providing an adjustable connection slot with a removable blanking plate, the nature of the adjustable connection slot can be changed between periods of operation of the substrate processing system by changing the removable blanking plate for an alternative removable blanking plate or by removing the removable blanking plate altogether, allowing different substrate modules to be connected to the adjustable connection slot. This allows the substrate processing system to be adjusted depending on the particular operational requirements of a substrate process to be performed, making the substrate processing system more flexible.

At least one of the least two load lock chambers can comprise a temperature control means that is configured to heat or cool a substrate within the at least one load lock chamber. The temperature control means can comprise a heat lamp, such as a spiral lamp heater. The temperature control means can comprise a cooled substrate support, such as a substrate support cooled by passing coolant fluid through tubes in the substrate support. By providing a temperature control means in at least one of the at least two load lock chambers, the substrate may be pre-heated or pre-cooled, as well as de-gassing, prior to entering the transfer vacuum chamber, reducing the substrate processing time inside the transfer vacuum chamber and potentially preventing the requirement for separate heating or cooling substrate modules, depending on the particular substrate process. In at least one of the load lock chambers that does not comprise a temperature control means, the at least one load lock chamber can comprise a Vacuum Cassette Elevator (VCE) or other means of accommodating multiple wafers within the respective at least one load lock chamber.

The at least one common substrate module can comprise a substrate processing module. The at least one common substrate module can comprise a multi-substrate buffer station. The at least one common substrate module can comprise at least two common substrate modules. By providing at least two common substrate modules that are accessible by both of the transfer robots, time spent by the transfer robots waiting for a common substrate module to be available to store or retrieve one or more wafers can be reduced, increasing the system throughput.

The at least two substrate modules can comprise at least nine substrate processing modules. In one configuration, the substrate processing system can comprise nine substrate processing modules, two common substrate modules and three load lock chambers. The at least two substrate modules can comprise a plurality of substrate processing modules that are each configured to perform the same process on a substrate. For example, the at least two substrate modules can comprise a plurality of substrate processing modules that are configured to perform a PVD process on a substrate. By having multiple substrate processing modules that can perform the same function, system throughput can be increased by processing multiple wafers in parallel simultaneously.

The substrate processing system can comprise at least one substrate alignment system. The at least one substrate alignment system can comprise a substrate alignment system associated with the EFEM. The at least one substrate alignment system can comprise a plurality of substrate alignment systems, wherein each substrate alignment system is associated with a respective connection slot. The at least one substrate alignment system can comprise at least two optical sensors that are configured to detect a translational or rotational misalignment of a substrate.

The substrate processing system can comprise at least one controller configured to control operation of at least one component of the substrate processing system. The substrate processing system can comprise a controller configured to control at least one of: the at least two substrate modules, the at least two load lock chambers, the at least two transfer robots, at least one connection slot valve, an EFEM, at least one temperature control means and at least one substrate alignment system.

The substrate processing system can comprise three load lock chambers, each load lock chamber having a respective internal surface, the transfer vacuum chamber can comprise a plurality of facets, each facet comprising at least one connection slot, each of the three load lock chambers being connected to the transfer vacuum chamber adjacent to one another at a common load lock facet and the transfer vacuum chamber can have a maximum internal width at the widest point of the transfer vacuum chamber, wherein the maximum distance between internal surfaces of the load lock chambers furthest apart from one another is less than 110% of the maximum internal width of the transfer vacuum chamber.

According to a second aspect of the invention, there is provided a method of processing a substrate using a substrate processing system according to the first aspect of the invention, wherein the method comprises:
- loading at least one substrate into one of the at least two load lock chambers in a loading step;
- retrieving a substrate from the one of the at least two load lock chambers into the transfer vacuum chamber using a first transfer robot in a load lock transfer step;
   disposing the substrate within a common substrate module in a common substrate module loading step;
- retrieving the substrate from the common substrate module using a second transfer robot and disposing the substrate within a substrate processing module in a common substrate module loading step;
- processing the substrate within the substrate processing module in a processing step.

The loading step can comprise loading one substrate into one of the at least two load lock chambers. When the loading step comprises loading one substrate into one of the at least two load lock chambers, after the loading step and before the load lock transfer step, the method can further comprise heating or cooling the substrate in the load lock chamber using a temperature control means.

The loading step can comprise loading a plurality of substrates into at least one of the at least two load lock chambers, wherein the load lock transfer step, common substrate module loading step, common substrate module unloading step and processing step are performed for each of the plurality of substrates.

The common substrate module can be a substrate processing module and, after the load lock transfer step and common substrate module loading step and before the common substrate module unloading step, the substrate can be processed in the common substrate module in an common substrate module processing step.

The substrate processing system can comprise a plurality of substrate processing modules, and the method can comprise further transfer steps of transferring at least one substrate between substrate processing modules and further processing steps of processing the at least one substrate within the respective substrate processing modules. For example, the method can comprise, after the load lock transfer step and before the common substrate module loading step, at least one step of disposing a substrate in a substrate processing module using the first transfer robot, processing the substrate in the substrate processing module and then retrieving the substrate from the substrate processing module using the first transfer robot.

### Description of Figures

Embodiments of the invention will now be described, by way of example only, with reference to the accompanying drawings, in which:
Figure 1 is a first perspective of a substrate processing system according to an embodiment of the invention;
Figure 2 is a second perspective of the substrate processing system according to an embodiment of the invention;
Figure 3 is a transfer vacuum chamber and EFEM of the substrate processing system according to an embodiment of the invention;
Figure 4 is a side view of a transfer vacuum chamber according to an embodiment of the invention;
Figure 5 is a schematic illustration of a transfer vacuum chamber according to an embodiment of the invention; and
Figure 6 is a flow chart illustrating steps of a method according to an embodiment of the invention.

### Detailed Description

The invention will be described with reference to an exemplary embodiment, in which the substrates to be processed are silicon wafers by a particular configuration of substrate modules, load lock chambers and transfer robots. However, the substrate processing system and method according to the invention are equally applicable to other forms of substrate and other configurations of substrate modules, load lock chambers and transfer robots.

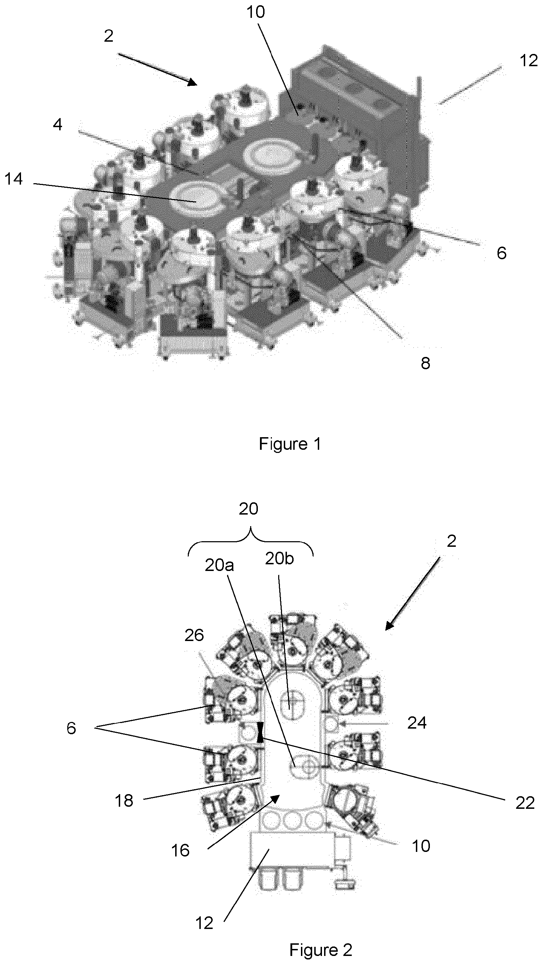

Figure 1 shows a first, isometric perspective of a substrate processing system 2 according to an embodiment of the invention and Figure 2 shows a second, cross-sectional perspective of a substrate processing system 2 according to an embodiment of the invention. The substrate processing system 2 comprises a single transfer vacuum chamber 4 for handling at least one substrate under vacuum conditions. The transfer vacuum chamber 4 comprises an interior chamber 16, defined by a wall 18, that is configured to be maintained under vacuum and can be formed from a single, integral piece of material, such as a monoblock of aluminium, to aid in maintaining the integrity of the vacuum within the interior chamber 16. The interior chamber 16 can have a maximum internal width at the widest point of the interior chamber 16. The vacuum within the interior chamber 16 is maintained by means of a vacuum pump (not shown), such as one or more cryopumps, which can maintain a vacuum having a pressure of less than 3×10⁻⁷ Torr, optionally less than 1×10⁻⁷ Torr, further optionally approximately 9×10⁻⁸ Torr. The transfer vacuum chamber 4 is in communication with nine substrate processing modules 6 and two auxiliary substrate modules 8 connected to the transfer vacuum chamber 4 by a respective connection slot 28, and further includes two viewing ports 14. One or more of the connection slots 28 can be provided with a slot valve 22, which can be selectively opened or closed to allow or prevent access to each attached module or load lock chamber. This allows the substrate processing modules 6 and/or auxiliary substrate modules 8 provided with a slot valve 22 to be isolated from the transfer vacuum chamber 4, which allows the substrate module 6, 8 to be maintained at a different pressure to the transfer vacuum chamber 4, for example by a respective vacuum pump (not shown). In one embodiment, each of the substrate processing modules 6 are connected to the transfer vacuum chamber 4 by a respective connection slot 28 including a slot valve 22, as substrate processing modules are often operated at a substantially higher pressures, for example one thousand times higher pressure, than that maintained in the transfer vacuum chamber 4. Each of the substrate processing module 6 can therefore be configured to receive a substrate from the transfer vacuum chamber 4 before the slot valve 22 is closed, bring the pressure within the substrate processing module to a target pressure and perform a process on the substrate. Each substrate processing module 6 can then be configured to reduce the pressure within the substrate processing module 6, prior to opening the slot valve 22 and allowing the substrate to be retrieved from the substrate processing module 6. If the pressure within the substrate processing module 6 is still higher than that inside the transfer vacuum chamber 4, the pressure inside the transfer vacuum chamber 4 will rise upon opening of the slot valve 22, but can be reduced again through operation of the vacuum pump associated with the transfer vacuum chamber 4. Auxiliary modules 8 that are configured to perform some form of process on the substrate, such as a multi- or single substrate cool down module or a pre-heat module, can also be connected to the transfer vacuum chamber 4 by a respective connection slot 28 including a slot valve 22 for the same reasons as the substrate processing modules 6. Auxiliary modules 8 that are not configured to perform a process on the substrate, such as a multi- or single substrate buffer module, do not require a slot valve 22 as part of their connection to the transfer vacuum chamber 4, as they can be maintained at the same pressure as the transfer vacuum chamber 4.

Each of the nine substrate processing modules 6 and two auxiliary substrate modules 8 are capable of receiving at least one substrate at a time. In the illustrated embodiment of Figures 1 and 2, the nine substrate processing modules 6 are each PVD modules capable of receiving one substrate at a time, and the two auxiliary modules 8 comprise one multi-substrate buffer station 24, capable of receiving and storing a plurality of substrates at any one time, and one dual-substrate cooling module 26, comprising two fluid-cooled substrate supports configured to cool substrates between processing steps carried out in the substrate processing modules 6. A buffer station 24, with or without a connection slot valve 22, can accommodate up to a plurality of substrates, such as up to twelve 300 mm wafers, and can improve "scheduling" of substrates within the substrate processing system 2, by freeing up a robot 20 end effector to move another substrate. A cooling module 26, typically connected to the transfer vacuum chamber 4 by a connection slot valve 22, allows cooling of substrates between processing steps, and can include fluid-cooled wafer supports and dedicated substrate pumping with purge gas lines (not shown).

The substrate processing system 2 further comprises three load lock chambers 10 in vacuum communication with the transfer vacuum chamber 4 and connected to a EFEM 12 configured to allow substrates to be loaded into and unloaded from the substrate processing system 2 from the atmosphere. The load lock chambers 10 are configured to reduce the atmospheric pressure within the load lock chambers 10 once substrates are loaded from the exterior of the substrate processing system 2 to allow substrates to be transferred from an external environment at a first atmospheric pressure into the vacuum maintained within the transfer vacuum chamber 4. Whilst three load lock chambers 10 are illustrated in the exemplary embodiment, it should be appreciated that different numbers of load lock chambers 10 may be provided, such as 2 or 4 or more, depending on the particular requirements of the substrate processing system 2. Similarly, the substrate processing system 2 can be configured to operate only a subsidiary of the load lock chambers 10 for substrate processing, for example by only using two of the three load lock chambers 10 for a particular process.

At least one of the load lock chambers 10 comprises a temperature control means (not shown) that is configured to heat or cool a substrate within the at least one load lock chamber 10. The temperature control means can comprise a heat lamp, such as a spiral lamp heater, which can be configured to raise the temperature of the substrate relative to the temperature of the substrate prior to loading into the load lock chamber 10. For example, a spiral lamp heater can uniformly heat a single 300 mm wafer from room temperature to 450°C in less than 60 seconds. The temperature control means can additionally or alternatively comprise a cooled substrate support, such as a substrate support cooled by passing coolant fluid through tubes in the substrate support, which can be configured to lower the temperature of the substrate relative to the temperature of the substrate prior to loading into the load lock chamber 10.

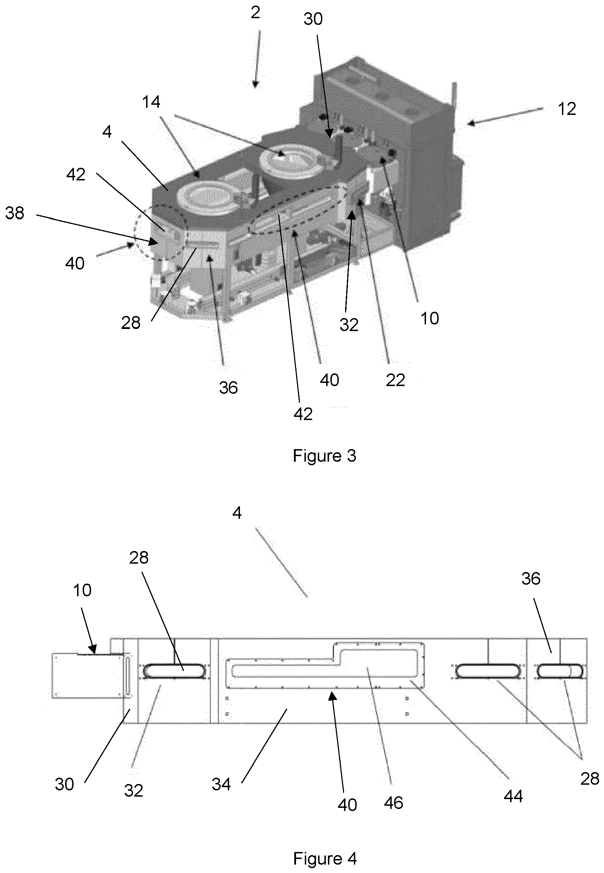

The transfer vacuum chamber 4 comprises a plurality of facets 30, 32, 34, 36, 38, as shown in Figure 3. Each facet 30, 32, 34, 36, 38 can be unique in shape or configuration, or can share its shape and/or configuration with at least one other facet, to facilitate the construction of the transfer vacuum chamber 4. For example, in the illustrated embodiment, the transfer vacuum chamber comprises a load lock facet 30, at which each of the three load lock chambers 10 are connected to the transfer vacuum chamber 4 adjacent to one another, two protruding facets 32 adjacent to the load lock facet 30 and three facets comprising at least one adjustable connection slot, side facets 34 and end facet 38. This is shown in Figures 3 and 4. However, other numbers of facets, and facet arrangements and configurations, may also be provided. Where three load lock chambers 10 are connected to the transfer vacuum chamber 4 at a single load lock facet 30, the maximum distance between internal surfaces of the load lock chambers furthest apart from one another can be less than 110% of the maximum internal width of the transfer vacuum chamber. This ensures that the overall width, and therefore the overall footprint, of the substrate processing system 2 is kept to a minimum.

Each facet 30, 32, 34, 36, 38 comprises at least one connection slot 28 and can include a plurality of connection slots 28. The protruding facets 32 are provided at either side of the load lock facet 30 and protrude at an angle from the transfer vacuum chamber 4, such that the protruding facets are inclined towards the EFEM 12 and the load lock chambers 10. In the illustrated embodiment, the protruding facets 32 are inclined at an angle of 15° to a normal of the plane containing the load lock facet 30. This configuration of facets has been found to maximise space around the protruding facets 32, allowing the option to mount larger substrate processing modules 6 adjacent to the load lock chambers 10, whilst minimising the footprint of the substrate processing system 2. Any of the facets 30, 32, 34, 36, 38 can comprise connection slots 28 of a standard size for connecting substrate processing modules 6 or auxiliary substrate modules 8, such as facets 36. For example, when handling 300 mm wafers, a standard PVD module would be approximately 820 mm wide and connected at a connection slot (approximately 400 mm in width) by a slot valve having an opening approximately 336 mm in width. However, facets 34, 38 comprising at least one adjustable connection slot 40 can interchangeably accommodate different substrate modules, such as substrate processing modules 6 or auxiliary substrate modules 8, or substrate modules that have a connection of a non-standard size. This is achieved by provision of at least one opening 42 in the facet 34, 38 that is typically larger than a corresponding opening configured to receive a substrate processing module 6 or an auxiliary substrate module 8. The at least one opening 42 is then at least partially covered by a blanking plate 44, comprising at least one aperture 46, that is removably secured to the facet 34, 38 by a removable securing means 48, such as screws. The at least one aperture 46 effectively provides a replacement opening in the facet 34, 38 to which substrate modules 6, 8 can be mounted. For example, as shown in Figure 3, protruding facet 32 and facet 36 each comprise connection slots 28 compatible with substrate processing modules 6 that can accommodate 300mm wafers. Facet 34 comprises one of these connection slots 28 as well as one opening 42 partially covered by a blanking plate 44 with a single aperture 46. The single aperture 46 is sized to accommodate a substrate processing module 6 on the left hand side of the aperture and an auxiliary substrate module having a larger connection size, such as a multi- or single substrate cool down module 26, a multi- or single substrate buffer module 24 or a metrology module. If the substrate modules connected to the transfer vacuum chamber 4 need to be changed, for example if the substrate processing system 2 is intended to be changed to perform a different process, then blanking plate 44 can be removed from the facet 34, 38 and replaced with an alternative blanking plate, or the at least one opening 42 can be left exposed. This change in configuration of the facet 34, 38 then allows different substrate modules 6,8, or different numbers of substrate modules 6, 8, to be mounted to the facet 34, 38.

The transfer vacuum chamber 4 comprises at least two transfer robots 20, located within the interior chamber 16. In one embodiment, the only components located inside the interior chamber 16 are the transfer robots 20. This allows the transfer robots 20 to have a relatively unimpeded movement path within the interior chamber 16, with only the other transfer robots 20 as a potential source of impediment. In the illustrated embodiment, the at least two transfer robots 20 comprise a first transfer robot 20a, located in a more proximal location to the three load lock chambers 10, and a second transfer robot 20b, located in a more distal location to the three load lock chambers 10. The exact positioning of the transfer robots 20 is chosen such that a first transfer robot, such as first transfer robot 20a, is capable of retrieving and disposing at least one substrate from each of the load lock chambers 10 and at least one common substrate module, and a second transfer robot, such as second transfer robot 20b, is capable of retrieving and disposing at least one substrate from the at least one common substrate module and at least one other substrate module. In the illustrated embodiment, the at least one common substrate module are the two auxiliary substrate modules 8. However, in other embodiments, the at least one common substrate module can be a substrate processing module 6, or a combination of one or more substrate processing modules 6 and one or more auxiliary substrate modules 8. If the at least one common substrate module is a substrate processing module 6, at least one handling step by the transfer robots 20 can be prevented, increasing the throughput of the substrate processing system 2.

Each of the transfer robots 20 is capable of translation along or rotation about at least five independent axes, and may be referred to as "five axis robots". Each robot 20 comprises at least one end effector configured to engage with and removably secure a substrate, to allow the robot 20 to translate the substrate from one location to another. In one embodiment, each robot 20 comprises two end effectors, with each end effector being configured to engage with and removably secure a respective substrate, allowing the robot 20 to interact with up to two substrates at any one time. By using five axis robots 20, any substrate handled by the robot can be maintained in a particular orientation, removing the requirement for a dedicated wafer orientation component.

The substrate processing system 2 can comprise at least one substrate alignment system (not shown). The at least one substrate alignment system can be located outside of the transfer vacuum chamber 4, such as in the EFEM 12 or associated with one or more connection slots 28. Whilst different substrate alignment systems are known in the art, in the illustrated embodiment, the substrate alignment system includes two optical sensors (not shown), which are configured to image a substrate passing through an imaging area and detect a translational or rotational misalignment of the substrate, for example by comparing an orientation of an imaged substrate with a predetermined "ideal" substrate orientation in a processor. The substrate alignment system can then affect alignment of the substrate, for example by informing a controller (not shown) of a misalignment and the controller controlling the most proximal robot 18 to rotate around and or translate along one or more axes to realign the substrate when it engages the substrate. If present, the controller can be configured to control any of the other components of the substrate processing system, such as other substrate modules 6, 8, the at least two load lock chambers 10, any other of at least two transfer robots 20, at least one connection slot valve 22, an EFEM 12, at least one temperature control means and any other substrate alignment systems.

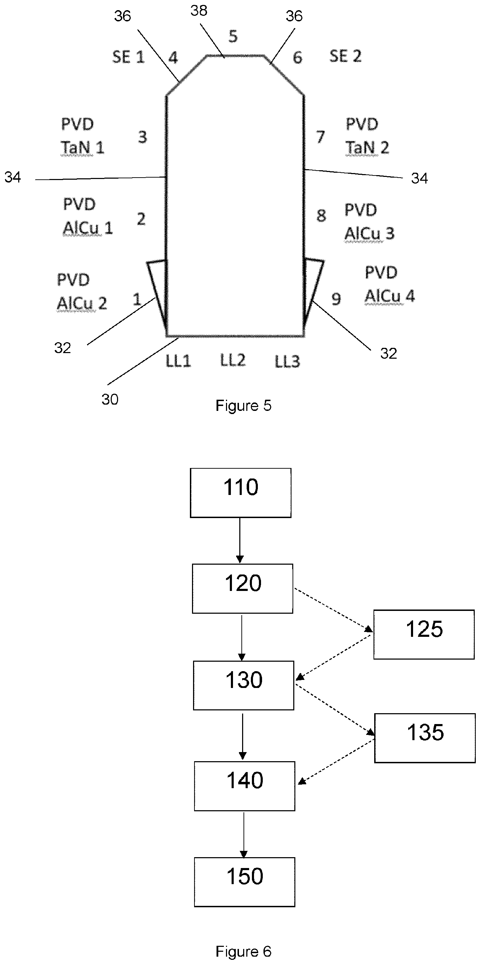

A method 100 of processing a substrate using a substrate processing system according to an embodiment of invention is shown in Figure 6. The method 100 comprises:
- loading at least one substrate into one of the at least two load lock chambers in a loading step 110;
- retrieving a substrate from the one of the at least two load lock chambers into the transfer vacuum chamber using a first transfer robot in a load lock transfer step 120;
   disposing the substrate within a common substrate module in a common substrate module loading step 130;
- retrieving the substrate from the common substrate module using a second transfer robot and disposing the substrate within a substrate processing module in a common substrate module unloading step 140;
- processing the substrate within the substrate processing module in a processing step 150.

The loading step 110 can comprise loading one substrate into one of the at least two load lock chambers. When the loading step 110 comprises loading one substrate into one of the at least two load lock chambers, after the loading step 110 and before the load lock transfer step 120, the method can further comprise heating or cooling the substrate in the load lock chamber using a temperature control means.

The loading step 110 can comprise loading a plurality of substrates into at least one of the at least two load lock chambers, wherein the load lock transfer step 120, common substrate module loading step 130, common substrate module unloading step 140 and processing step 150 are performed for each of the plurality of substrates.

The common substrate module can be a substrate processing module and, after the load lock transfer step 120 and common substrate module loading step 130 and before the common substrate module unloading step 140, the substrate can be processed in the common substrate module in an common substrate module processing step 135.

The substrate processing system can comprise a plurality of substrate processing modules, and the method can comprise further transfer steps of transferring at least one substrate between substrate processing modules and further processing steps of processing the at least one substrate within the respective substrate processing modules, effectively repeating the load lock transfer step 120, common substrate module loading step 130, common substrate module unloading step 140 and processing step 150 and optionally the common substrate module processing step 135 and optionally introducing additional processing and handling steps. For example, the method can comprise, after the load lock transfer step 120 and before the common substrate module loading step 130, disposing a substrate in a substrate processing module using the first transfer robot, processing the substrate in the substrate processing module and then retrieving the substrate from the substrate processing module using the first transfer robot (step 125). This step 125 can be repeated multiple times, for example in different substrate processing modules, before the common substrate module loading step 130 is performed.

### Example

An example of a configuration of the substrate processing system 2 is provided below. The substrate processing system 2 is configured to perform a AlCu deposition on a silicon wafer to form 3 µm bond pads and is shown in Figure 5. The AlCu deposition process comprises pre-heating the wafer followed by soft sputter etching the wafer, physical vapour deposition of TaN and physical vapour deposition of AlCu. Such a deposition process requires four separate processing steps, and therefore represents a process at or close to the handling limit for a typical substrate processing system. In order to provide this, the substrate processing system 2 is configured to include three load lock chambers 10 (LL1, LL2, LL3), each load lock chamber 10 comprising a temperature control means configured to pre-heat the wafers before the wafers are taken into the transport vacuum chamber 4, and nine substrate processing module positions, as illustrated in Figure 5, of which eight are used. In particular, soft sputter etch chambers (SE1, SE2) are provided in positions 4 and 6 and physical vapour deposition modules are provided in positions 1, 2, 3, 7, 8 and 9, of which two are configured to perform PVD of TaN (PVD TaN 1, PVD TaN 2) and four are configured to perform PVD of AlCu (PVD AlCu 1, PVD AlCu 2, PVD AlCu 3, PVD AlCu 4). The at least one common substrate module in this case is provided by two auxiliary substrate modules, with an auxiliary substrate modules located between positions 2 and 3 and positions 7 and 8 respectively. In this case, the two auxiliary modules would each be buffer modules. The longest residence time of wafers is during the PVD of AlCu, with a duration of approximately 200 seconds, this therefore represents the main limitation on the throughput of the substrate processing system 2. By providing multiple AlCu PVD modules, multiple wafers can undergo PVD of AlCu at the same time which, along with the provision of at least two TaN PVD modules and at least two soft sputter etch chambers, allows at least two wafers to be processed by the substrate processing system 2 at any one time. This significantly increases the throughput of the substrate processing system 2, allowing 60 wafers to be processing per hour. A comparable octangle substrate processing system with two soft sputter etch chambers, two PVD TaN modules, two PVD AlCu modules and a bi-symmetric robot, even with two pre-heating load lock chambers, could only achieve 32 wafers processed per hour.

## Claims

1. A substrate processing system comprising:
• a transfer vacuum chamber for handling a substrate under vacuum conditions, the transfer vacuum chamber being in communication with at least two substrate modules connected to the transfer vacuum chamber by a respective connection slot, the at least two substrate modules being capable of receiving at least one substrate, wherein at least one of the at least two substrate modules is a substrate processing module; and
• at least two load lock chambers in vacuum communication with the transfer vacuum chamber;
wherein the transfer vacuum chamber comprises at least two transfer robots disposed within the transfer vacuum chamber configured to transfer a substrate between the at least two load lock chambers and the at least one substrate processing module under vacuum conditions, wherein the at least two transfer robots are each capable of translation along or rotation about at least five independent axes, and the at least two transfer robots are each configured to dispose and retrieve a substrate from at least one common substrate module of the at least two substrate modules.

2. A substrate processing system according to claim 1, wherein the at least two load lock chambers are connected to an Equipment Front End Module (EFEM) configured to allow substrates to be loaded into and unloaded from the substrate processing system.

3. A substrate processing system according to claim 1 or claim 2, wherein the transfer vacuum chamber comprises a plurality of facets, each facet comprising at least one connection slot, wherein each of the at least two substrate modules and the at least two load lock chambers are connected to the transfer vacuum chamber at a facet by a respective connection slot; wherein optionally each of the at least two load lock chambers are connected to the transfer vacuum chamber at a common load lock facet; and wherein further optionally the at least two load lock chamber comprises three load lock chambers, wherein each of the three load lock chambers are connected to the transfer vacuum chamber at the load lock facet.

4. A substrate processing system according to claim 3, wherein the transfer vacuum chamber comprises two facets adjacent to the load lock facet, wherein each of the two facets are inclined toward the load lock facet.

5. A substrate processing system according to claim 3 or claim 4, wherein at least one facet comprises an adjustable connection slot and, optionally, wherein three facets comprise a respective adjustable connection slot; wherein further optionally the adjustable connection slot comprises at least one opening in the facet of the transfer vacuum chamber and a blanking plate, the blanking plate comprising at least one aperture, wherein the blanking plate is removably secured to the facet such that the least one aperture is positioned over the at least one opening.

6. A substrate processing system according to any one of claims 1 to 5, wherein at least one of the at least two load lock chambers comprises a temperature control means that is configured to heat or cool a substrate within the at least one load lock chamber; and wherein, optionally, the temperature control means comprises a heat lamp.

7. A substrate processing system according to claim 6, wherein the temperature control means comprises a cooled substrate support.

8. A substrate processing system according to any one of claims 1 to 7, wherein the at least one common substrate module comprises a substrate processing module.

9. A substrate processing system according to any one of claims 1 to 8, wherein (i) the at least one common substrate module comprises a multi-substrate buffer station; and/or (ii) the at least one common substrate module comprises at least two common substrate modules; and/or the at least two substrate modules comprise at least nine substrate processing modules.

10. A substrate processing system according to any one of claims 1 to 9, wherein the substrate processing system comprises at least one substrate alignment system; and wherein, optionally, the at least one substrate alignment system comprises a plurality of substrate alignment systems, wherein each substrate alignment system is associated with a respective connection slot and/or the at least one substrate alignment system comprises at least two optical sensors that are configured to detect a translational or rotational misalignment of a substrate.

11. A substrate processing system according to any one of claims 1 to 10, wherein the substrate processing system comprises three load lock chambers, each load lock chamber having a respective internal surface, the transfer vacuum chamber comprises a plurality of facets, each facet comprising at least one connection slot, each of the three load lock chambers being connected to the transfer vacuum chamber adjacent to one another at a common load lock facet and the transfer vacuum chamber has a maximum internal width at the widest point of the transfer vacuum chamber, wherein the maximum distance between internal surfaces of the load lock chambers furthest apart from one another is less than 110% of the maximum internal width of the transfer vacuum chamber.

12. A method of processing a substrate using a substrate processing system according to any one of claims 1 to 11, wherein the method comprises:
• loading at least one substrate into one of the at least two load lock chambers in a loading step;
• retrieving a substrate from the one of the at least two load lock chambers into the transfer vacuum chamber using a first transfer robot in a load lock transfer step;
• disposing the substrate within a common substrate module in a common substrate module loading step;
• retrieving the substrate from the common substrate module using a second transfer robot and disposing the substrate within a substrate processing module in a common substrate module unloading step;
• processing the substrate within the substrate processing module in a processing step.

13. A method according to claim 12, wherein the loading step comprises loading one substrate into one of the at least two load lock chambers; and wherein optionally, after the loading step and before the load lock transfer step, the method further comprises heating or cooling the substrate in the load lock chamber using a temperature control means.

14. A method according to claim 12 or claim 13, wherein the loading step comprises loading a plurality of substrates into at least one of the at least two load lock chambers, and the load lock transfer step, common substrate module loading step, common substrate module unloading step and processing step are performed for each of the plurality of substrates and/or wherein the common substrate module is a substrate processing module and, after the load lock transfer step and common substrate module loading step and before the common substrate module unloading step, the substrate is processed in the common substrate module in an common substrate module processing step.

15. A method according to any one of claims 12 to 14, wherein the substrate processing system comprises a plurality of substrate processing modules, and the method comprises further transfer steps of transferring at least one substrate between substrate processing modules and further processing steps of processing the at least one substrate within the respective substrate processing modules; wherein optionally the method further comprises, after the load lock transfer step and before the common substrate module loading step, at least one step of disposing a substrate in a substrate processing module using the first transfer robot, processing the substrate in the substrate processing module and then retrieving the substrate from the substrate processing module using the first transfer robot.
